Europäisches Patentamt

European Patent Office

Office européen des brevets

(11) Publication number: 0 513 634 A2

# EUROPEAN PATENT APPLICATION

(21) Application number: 92107566.9

(22) Date of filing: 05.05.92

(51) Int. Cl.⁵: **C23C 16/44**, C23C 16/50

(30) Priority: **14.05.91 JP 139750/91**

(43) Date of publication of application:
**19.11.92 Bulletin 92/47**

(84) Designated Contracting States:
**DE FR GB**

(71) Applicant: **Mori, Yuzo**
**16-9, 8-chome Kisaichi**
**Katano-shi Osaka 576(JP)**
Applicant: **UHA MIKAKUTO PRECISION**
**ENGINEERING RESEARCH INSTITUTE Co.,**
**Ltd.**
**4-12, Kanzaki-cho, Chuo-ku**
**Osaka-shi, Osaka 540(JP)**

(72) Inventor: **Mori, Yuzo**
**16-9 Kisaichi 8-chome**
**Katano-shi, Osaka 576(JP)**

(74) Representative: **Vossius & Partner**
**Siebertstrasse 4 P.O. Box 86 07 67**
**W-8000 München 80(DE)**

(54) **High-speed film-forming processes by plasma CVD and Radical CVD under high pressure.**

(57) High-speed film-forming processes by plasma CVD and radical CVD under a high pressure which enable high-speed film forming without few restrictions on a substrate and polycrystallization or crystallization of a thin film merely by heating the substrate to a temperature which does not cause thermal damage on the substrate. The long-life neutral radicals of an inert gas are generated by excitation of plasma or light under a high pressure such as several Torr to several atm, and the neutral radicals are reacted with reaction gas molecules so as to decompose or activate reaction nuclei. The neutral radicals of the reaction gas generated thereby are introduced onto the substrate, thereby forming a thin film thereon.

FIG.1

The present invention relates to high-speed film-forming processes by plasma CVD and radical CVD under a high pressure and, more particularly, to high-speed film-forming processes which are free from a damage to the substrate caused by charged particles and a thermal damage to the substrate due to heat.

Conventional techniques of forming a thin film on a substrate are classified broadly into physical methods (physical vapor deposition, PVD) and chemical methods (chemical vapor deposition, CVD). In the field of electronics, plasma CVD, which is one of the chemical methods, is especially attracting attention. Plasma CVD has advantages in that, for example, (1) it is possible to freely control the temperature of a substrate at the time of forming neutral radicals or ions, which are the reaction nuclei in the plasma, and (2) since plasma in a high-energy state is utilized, plasma CVD is applicable to a reaction which is generally difficult. As a means for generating and maintaining plasma, R.F. electric field, microwaves, milliwaves, light, etc. are used in addition to a DC electric field and a commercial frequency of 50/60 Hz. Especially, plasma CVD under a high vacuum ($10^{-3}$ to $10^{-5}$ Torr) which uses ECR plasma has recently been adopted.

In such low-pressure plasma, however, what is called unbalanced plasma in which only the electron temperature is very high is generated, so that the energy of the electrons produced in the plasma becomes very high and the electrons may collide directly with the substrate in some electric fields. In addition, due to a low pressure, the film-forming speed is disadvantageously low.

Conventional plasma CVD, for example, thermal CVD which is generally adopted for forming a polycrystalline silicon (Si) film requires a substrate to be heated to 1,000 to 2,000°C. Exposure to such a high temperature produces relative diffusion of the elements which constitute the substrate and the thin film, and if the element which constitutes the substrate is different from the element which constitutes the thin film and a trace amount of element is contained in the substrate, impurities may be introduced into the thin film. In producing a polycrystalline silicon thin film by heat treatment at a comparatively low temperature, an amorphous silicon thin film is first formed and thereafter the substrate is heated to 600 to 700°C so as to accelerate crystallization.

As described above, in order to control the crystalline structure of the thin film produced on a substrate, it is necessary to heat the substrate to at least 600°C in the prior art. For this reason, not only is it impossible to use a low-melting material for the substrate but also there is a possibility of causing thermal damage to the substrate. In addition, since a high electric filed is necessary for directly exciting the reaction gas in order to generate plasma, the charged particles obtained thereby and having a high kinetic energy are introduced to the substrate, thereby causing a defect in the thin film or the substrate.

Accordingly, it is an object of the present invention to eliminate the above-described problems in the prior art and to provide high-speed film-forming processes by plasma CVD and radical CVD under a high pressure which enable film formation at a high speed by generating the plasma of a carrier gas consisting of an inert gas which is easy to produce and maintain under a high pressure such as several Torr to several atm and by decomposing and activating reaction gas molecules in a gas phase or on a substrate by the plasma so as to generate neutral radicals having a high density and grow a thin film on the substrate, and which enable the polycrystallization or crystallization of the thin film merely by heating the substrate to a temperature of not higher than 300°C which generally cause no thermal damage to the substrate of almost any material.

To achieve this aim, the present invention provides a high-speed film-forming process by plasma CVD under a high pressure comprising the steps of: decomposing and activating reaction gas molecules by the long-life neutral radicals of an inert gas which is produced by excitation by plasma or light under a high pressure such as several Torr to several atm; and introducing the neutral radicals of the reaction gas generated thereby onto the substrate so as to form a thin film.

The present invention also provides a high-speed film-forming process under a high pressure comprising the steps of: generating the long-life radicals of an inert gas produced by excitation by plasma or light under a high pressure such as several Torr to several atm; taking out only the neutral radicals and decomposing or activating reaction nuclei by the interaction between the neutral radicals and the reaction gas in the vicinity of a substrate; and introducing the neutral radicals of the reaction gas generated thereby onto the substrate so as to form a thin film.

The long-life neutral radicals of an inert gas are generated by a high-frequency electromagnetic field of 10 MHz to 100 GHz or light.

In a high-speed film-forming process by plasma CVD under a high pressure according to the present invention, the long-life radicals of an inert gas are first generated by excitation by plasma or light under a high pressure such as several Torr to several atm in the mixture of a carrier gas consisting of the inert gas and a reaction gas for supplying reaction nuclei. The reaction gas molecules are then directly decomposed or activated by the inelastic collision of the neutral radicals and the reaction gas molecules or by the excitation by the plasma or light so as to generate the neutral radicals of the reaction gas molecules. These neutral radicals are introduced onto a substrate to grow a thin film thereon. Since the neutral radicals of the inert gas molecules constantly act on the surface of the substrate, it is possible to control the crystallinity of the thin film.

In a high-speed film-forming process by radical CVD under a high pressure according to the present invention, plasma is generated from a carrier gas consisting of an inert gas under a high pressure such as several Torr to several atm and excited, or the carrier gas is irradiated with light for the purpose of optical pumping, thereby generating the long-life neutral radicals of the inert gas. The neutral radicals of the inert gas are then taken out of the region in which the plasma has been generated or the region in which the plasma has excited the inert gas, and are mixed with a reaction gas in the vicinity of a substrate so as to cause inelastic collision between the neutral radicals of the inert gas and the reaction gas molecules. The neutral radicals of the reaction gas generated in this way are introduced onto the substrate to grow a thin film thereon. Since the neutral radicals of the inert gas molecules constantly act on the surface of the substrate, it is possible to control the crystallinity of the thin film.

The neutral radicals of the inert gas have an energy of about several eV to several ten eV. This energy is much larger than the thermal energy produced by the heating temperature of about 1,000 to 1,200°C in general CVD. Since these neutral radicals are introduced onto the substrate at such a low kinetic energy as not to cause a damage such as a lattice defect to the substrate and they have a high density, the radicals in the state of electrons supply a sufficiently high energy for the crystallization of the thin film. It is therefore unnecessary to heat the substrate to a high temperature, and a heating temperature of room temperature to not higher than 300°C is enough. Thus, the substrate is free from thermal damage, and it is possible to form a crystallized thin film such as polycrystalline silicon on a substrate of a cheap or low-melting material such as glass, metal plate and polymeric film. In other words, the process of the present invention is characterized in that in forming a crystallized thin film such as polycrystalline silicon on a given substrate, the crystalline structure is controlled not by the substrate temperature but by the energy of radicals.

The above and other objects, features and advantages of the present invention will become clear from the following description of the preferred embodiments thereof, the appended claims and the accompanying drawings.

Fig. 1 schematically shows the arrangement of an opposed-electrodes type plasma CVD apparatus;

Fig. 2 is a schematic side elevational view of a microwave plasma CVD apparatus;

Fig. 3 is a schematic vertical sectional view of the reactor in the apparatus shown in Fig. 2;

Fig. 4 is a schematic side elevational view of a radical CVD apparatus;

Fig. 5 is a vertical sectional view of the main part of the apparatus shown in Fig. 4;

Fig. 6 is a schematic sectional view of a reactor in which a parallel plate electrode composed of a substrate and an electrode are disposed;

Fig. 7 is a schematic sectional view of a reactor in which a grounded grid is inserted between a substrate and an electrode;

Fig. 8 is a schematic sectional view of a reactor in which a substrate is disposed on a longitudinal side of opposed electrodes;

Fig. 9 is a partially schematic perspective view of an acicular electrode and a substrate;

Fig. 10 is a schematic sectional view of an acicular electrode provided therein with a gas passage and a substrate;

Fig. 11 is a partially schematic perspective view of a blade electrode and a substrate;

Fig. 12 is a partially schematic perspective view of a blade electrode provided therein with a gas passage and a substrate;

Fig. 13 is a schematic sectional view of a reactor composed of a rectangular cavity microwave resonator and a substrate disposed therein;

Fig. 14 is a schematic sectional view of a reactor composed of a rectangular cavity microwave resonator and a substrate disposed in the reaction space thereof;

Fig. 15 is a schematic sectional view of a reactor composed of a rectangular cavity microwave resonator and a substrate disposed in the plasma region of a reaction tube which penetrates through the resonator;

Fig. 16 is a schematic sectional view of a reactor composed of a rectangular cavity microwave resonator and a substrate disposed out of the plasma region of a reaction tube which penetrates through the resonator;

Fig. 17 is a schematic sectional view of a reactor composed of a rectangular cavity microwave resonator, a gas supply pipe inserted into a reaction tube which penetrates through the resonator, and a substrate disposed out of the plasma region of the reaction tube;

Fig. 18 is a schematic sectional view of a rectangular cavity microwave resonator and a reactor into which an antenna is lead out of the resonator and in which a substrate is disposed in the plasma region;

Fig. 19 is a schematic sectional view of a rectangular cavity microwave resonator and a reactor into which an antenna is lead out of the resonator and in which a substrate is disposed out of the plasma region;

Fig. 20 is a schematic sectional view of a reactor composed of a reentrant semicylindrical cavity resonator and a substrate disposed in the gap thereof;

Fig. 21 is a schematic sectional view of a reactor composed of a reentrant semicylindrical cavity resonator and a substrate disposed in the reaction space out of the gap thereof;

Fig. 22 is a schematic sectional view of a modification of the apparatus shown in Fig. 19, the modification composed of a rectangular cavity microwave resonator and a reactor into which a T-shaped antenna is lead out of the resonator and in which a relatively moving substrate is disposed out of the plasma region; and

Fig. 23 is a schematic perspective view of the apparatus shown in Fig. 22.

In the present invention, a carrier gas consisting of an inert gas is excited by plasma or light under a high pressure such as several Torr to several atm so as to generate the long-life neutral radicals of the inert gas, and the neutral radicals are brought into inelastic collision with reaction nuclei so as to generate the neutral radicals of the reaction gas. The neutral radicals of the reaction gas are decomposed in a gas phase or on the substrate disposed in the vicinity of the region in which the neutral radicals are generated, thereby growing the thin film of the elements which constitute the reaction nuclei.

In the present invention, it is possible to separate the region in which the inert gas is excited by plasma or light from the region in which the neutral radicals are generated from the reaction nuclei. In this case, the neutral radicals of the inert gas are taken out of the region in which the inert gas has been excited, and the neutral radicals taken out are mixed with a reaction gas in another region so as to bring the neutral radicals into inelastic collision with the reaction gas, thereby generating the neutral radicals of the reaction gas.

As a means for exciting and activating the inert gas, plasma or light is used. For this purpose, plasma is generated from a part of the inert gas in a high-frequency electromagnetic field of 10 MHz to 100 GHz, the remaining neutral atoms are excited and activated by the inelastic collision between the plasma and the remaining neutral atoms, thereby generating neutral radicals. Alternately, the neutral atoms of the inert gas are irradiated with light (including ultraviolet rays and infrared rays) of a wavelength having a high absorptive efficiency so as to generate the neutral radicals by direct excitation and activation. However, the exciting means is not specified.

Gases used in the present invention will now be described. As the inert gas used as the carrier gas, helium (He) and argon (Ar) are suitable, but neon (Ne), krypton (Kr) and xenon (Xe) are also usable. They are used either singly or in the form of a mixture, as occasion demands. The reaction gas for supplying the reaction nuclei is appropriately selected in accordance with the type of the thin film formed on the substrate. For example, in the case of forming a silicon thin film, silane ($SiH_4$) is mainly used. $SiF_4$, $SiC\ell_4$, $Si_2H_6$, $SiHC\ell$, etc. are also used. In the case of doping phosphorus (P) or boron (B) in the silicon thin film, an appropriate amount of $PH_3$, $B_2H_6$ or the like is mixed with the reaction gas.

In the present invention, since the heating temperature for the substrate is as low as not higher than 300°C, almost any material can be used for the substrate. For example, glass, metal and polymeric film are usable. Since plasma or radical reaction is utilized in forming a film on the substrate, various kinds of materials such as semiconductors, diamond, alloys, oxides, nitrides, carbides and silicates are usable as a material for the thin film. For example, Si, $SiO_2$, $SnO_2$, TiC, TiN, $A\ell_2O_3$, CBN, SiC are used. Table 1 shows examples of the type of the thin film and the reaction gas (synthesis gas).

Table 1

| Type of thin film and reaction gas used for film forming | |
|---|---|
| CVD thin film | Reaction gas (Synthesis gas) |
| Polycrystalline Si | $SiH_4 \ (+ \ H_2)$, $SiC\ell_4 \ (+ \ H)$ |
| Diamond | $CH_4$, $CO$, $CO_2$, $C_2H_2$, etc. |
| TiC | $TiC\ell_4 \ + \ H$ |
| TiN | $TiC\ell_4 \ + \ NH_3 \ (+ \ H)$ |
| $Si_3N_4$ | $SiH_4 \ + \ NH_3$, $SiC\ell_4 \ + \ NH_3 \ + \ H_2$, etc. |
| $SiO_2$ | $SiH_4 \ + \ O_2$, $SiH_4 \ + \ CO_2$, $SiC\ell_4 \ + \ H_2O$, |
| | $SiC\ell_4 \ + \ CO_2 \ + \ H_2$ |
| $A\ell_2O_3$ | $A\ell(C_2H_5)_3 \ + \ O_2$ |

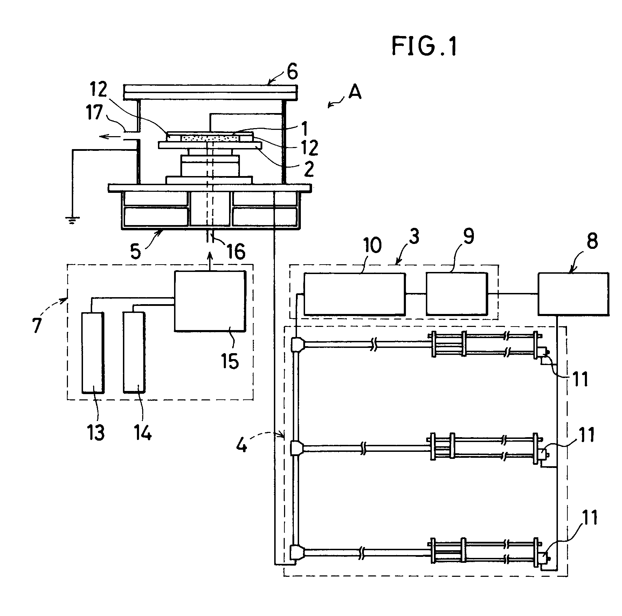

The present invention will be explained in more detail with reference to the embodiments shown in the accompanying drawings. Fig. 1 shows an opposed-electrodes type plasma CVD apparatus A for forming a thin film on a substrate 1 by applying a high-frequency voltage to a plate electrode 2 so as to generate plasma in the gap of a parallel plate electrode constituted by the substrate 1 and the plate electrode 2. This apparatus is composed of a high-frequency power source 3 for applying a high-frequency voltage to the electrode 2, a matching circuit 4 for matching the impedances of the high-frequency power source 3 and the load, a cavity resonator 5 for boosting the high-frequency voltage supplied from the high-frequency power source 3, a reactor 6 which is connected to the cavity resonator 5 and accommodating the substrate 1 and the electrode 2, a gas supply unit 7 for supplying a carrier gas and a reaction gas to the reactor 6, and a controller 8 composed of a computer for outputting a control signal to each element on the basis of the signal input from a sensor for detecting the state of each element. The reactor 6 can seal up an atmospheric gas in a hermetic or flowing state up to about 10 atm.

The movable portion of each element is driven by a driving motor such as a stepper motor and a serve motor, and a change in motion is detected by each sensor. When the information on the detection is fed back to the controller 8, the controller 8 controls the driving motor so that the preset optimum state is obtained. The controller 8 controls the frequency of the high-frequency power source 3, tunes the matching circuit 4, controls the pressure in the reactor 6 by adjusting the flow rates of the carrier gas and the reaction gas, and changes the relative position of the substrate and the electrode 2, if necessary.

In the present invention, by generating and maintaining plasma in an atmosphere of a high-pressure gas, the density of the neutral radicals of the reaction gas excited and activated by the plasma is increased and the film-forming speed is increased, and further the crystalline structure of the thin film formed on the substrate is controlled. However, it is generally difficult to generate and maintain the plasma of a reaction gas. Therefore, an inert gas which can easily generate and maintain plasma is first excited by a high-frequency electric field so as to generate plasma. In this case, not all the inert gas becomes plasma but almost all remains neutral atoms. These neutral atoms collide with the electrons and ions which constitute the plasma and are excited to become neutral radicals. Since the neutral radicals of the inert gas has a long life and assumes a metastable state, they repeat collision with the reaction gas and excite and activate the reaction gas, thereby generating the neutral radicals of the reaction gas. If the reaction gas is present in the plasma generating region, the neutral radicals of the reaction gas are also generated by the direct excitation by the electrons.

The opposed-electrodes type plasma CVD apparatus A will be explained in more detail. In the high-frequency power source 3, an amplifier 10 amplifies a high-frequency signal of 146 MHz band which is generated by a signal generator 9. The frequency and the output of the signal generator 9 are controlled by the controller 8. The output of the high-frequency power source 3 is supplied to the cavity resonator 5 through the matching circuit 4. The matching circuit 4 is composed of a stub tuner, and the movable short-circuit end thereof sets the high-frequency reflection loss to the minimum by a driving motor 11 which is pulse-controlled. The high-frequency signal is boosted by the flat reentrant cylindrical cavity resonator 5 which is composed of a conductor, and the high voltage obtained thereby is introduced to the reactor 6 through a DC introducing terminal and applied to the electrode 2. The electrode 2 is a discal plate electrode and a spacer 12 is inserted between the electrode 2 and the substrate 1 to form a gap therebetween.

Plasma is generated and maintained in the gap. The gas supply unit 7 is provided with a carrier gas bomb 13 and a reaction gas bomb 14, mixes the carrier gas and the reaction gas in a reserve tank 15 which is connected to the carrier gas bomb and the reaction gas bomb 14 and supplies the mixed gas from a supply port 16 of the reactor 6 to the gap through a gas inlet at the center of the electrode 2. The gas flow rate is so controlled that the pressure in the gap is between several Torr and 10 atm by operating a flow rate adjusting needle valve provided between the reactor 6 and the reserve tank 15, and a flow rate adjusting valve provided on the outlet 17 side of the reactor 6. It is naturally possible to introduce the carrier gas and the reaction gas to the reactor 6 separately from each other. It is further possible to supply the carrier gas to the plasma generating region and take out the neutral radicals of the inert gas generated therein, and to supply the reaction gas to a region different from the plasma generating region and mix the neutral radicals with the reaction gas in that region.

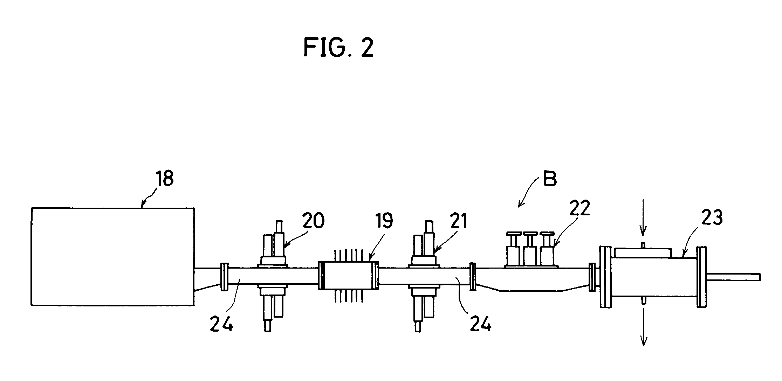

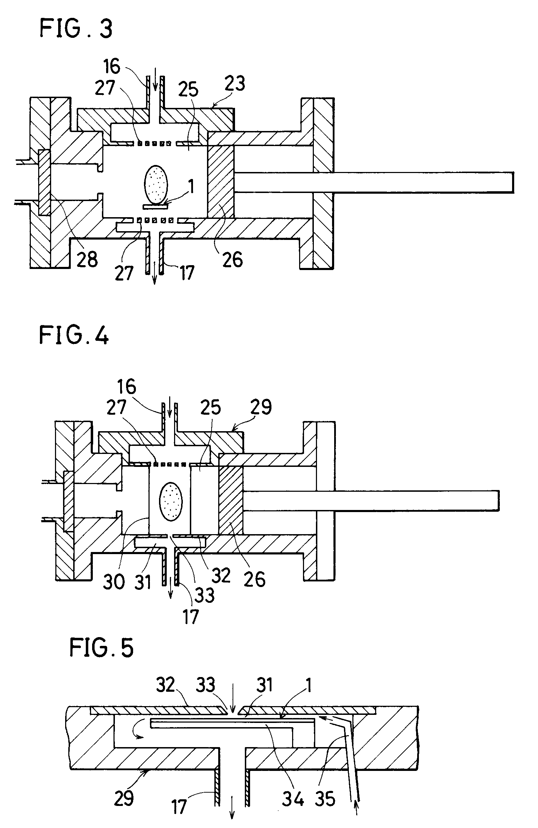

A microwave plasma CVD apparatus B will now be explained with reference to Figs. 2 and 3. This apparatus adopts a plasma generation system utilizing a stationary wave of a microwave which can easily generate and maintain plasma even under a high pressure such as not less than 1 Torr. By resonating a microwave in a reaction chamber which is used as a cavity resonator, it is possible to obtain a high electric field strength without using an electrode and to generate and maintain plasma even under a high pressure.

The microwave plasma CVD apparatus B is composed of a microwave generator 18 using a magnetron, an isolator 19, a travelling wave output monitor 20, a reflected wave output monitor 21, a three-stub tuner 22 and a reactor 23.

The microwave generator 18, which has an oscillation frequency of 2450 ± 30 MHz, generates a microwave output of 10 to 1,000 W by controlling the anode current of the magnetron and feeds back the travelling wave output to the anode current. In this way, the microwave generator 18 has an output stability of ± 5%.

The microwave output from the microwave generator 18 is introduced to the isolator 19 through a rectangular waveguide which has a cut-off frequency of 1.56 GHz in the $TE_{10}$ mode and which does not propagate a microwave in a higher-order mode at not more than 3.13 GHz. The isolator 19 is composed of a circulator which utilizes the deflection due to the anisotropy of a ferrite in a magnetic field and a microwave absorber. The circulator portion is divided into several portions in the horizontal direction (H surface), and a magnetic field is applied to the division points by the ferrite and the magnetron. The microwave is bent in the horizontal direction at these points and connected from the magnetron side to the load side, from the load side to the absorber side and from the absorber side to the magnetron side. Therefore, although the microwave from the magnetron travels to the load side, the reflected wave from the load side is bent at the circulator portion and proceeds to the absorber side, and the magnetoelectric wave which enters the absorber as the matched non-reflection end is all absorbed, so that the reflected wave does not return to the magnetron side.

The travelling wave output monitor 20 is provided between the magnetron of the microwave generator 18 and the isolator 19, and the reflected wave output monitor 21 is provided between the isolator 19 and the three-stub tuner 22. Each of these monitors can take out the electromagnetic field which is proportional only to the magnitude of the travelling wave or the reflected wave, and takes out the travelling wave power or the reflected wave power separately from each other by detecting the electromagnetic field by a diode.

The three-stub tuner 22 is composed of three retractable conductor rods arranged with a space of λ/4 (40 mm). By adjusting the height of each conductor rod, the degree of reflection is electromagnetically changed, and by the interference of the reflected wave from the three stubs and the reflected wave from the load, it is possible to reduce the reflected wave. Theoretically, matching with the impedance of any load is possible.

The microwave enters the reactor 23 through each of these elements. As shown in Fig. 3, the reaction chamber of the reactor 23 constitutes a rectangular cavity resonator 25, and the end thereof constitutes a movable short-circuit end 26. By adjusting the movable short-circuit end 26, the resonance frequency is set at 2.45 GHz and by producing a large stationary wave in the reactor 23, plasma is generated and maintained. The reactor 23 is provided with the supply port 16 for the carrier gas and the reaction gas, and the outlet 17, and causes gas flow through a mesh 27 provided on the boundary of the magnetoelectric space which constitutes the rectangular cavity resonator 25. The substrate 1 is disposed in the rectangular cavity resonator 1. The reactor 23 withstands a pressure between a vacuum to 10 atm. The reactor 23 is also provided with a silica glass window 28 for introducing the microwave therethrough. The size of the rectangular cavity resonator 25 is set to be optimum in accordance with the frequency and the mode of the microwave and the size of the substrate 1 accommodated in the rectangualr cavity resonator 25. The structure of the rectangular cavity resonator 25 is not restricted to the structure shown in Figs. 2 and 3.

A radical CVD apparatus C will now be explained with reference to Figs. 4 and 5. In the opposed-electrodes type CVD apparatus C, since a high-frequency voltage is applied to the electrode 2 and high-frequency plasma is generated between the substrate 1 and the electrode 2, the substrate 1 is exposed to the plasma. Therefore, there is a fear of a part of charged particles reaching the substrate 1 and damaging the substrate 1. In the microwave plasma CVD apparatus B, since the rectangular cavity resonator 25 is used as the reaction chamber, a high field strength is obtained and high-pressure plasma is maintained. On the other hand, since the field strength concentrates on the vicinity of the center of the reaction chamber, the plasma region obtained is narrow and the size of the substrate 1 may be restricted to a small size. In addition, since the substrate is placed in high-pressure plasma, the material of the substrate 1 is restricted to a material having a low dielectric loss. Accordingly, if the plasma region and the thin-film-forming region are separated from each other, it is possible to grow a thin film uniformly on a low-temperature substrate having a large area, and any given material is usable for the substrate 1. The radical CVD apparatus C realizes this concept.

Radical CVD is a technique of forming a thin film by decomposing or activating reaction gas molecules by the long-life neutral radicals of an inert gas which are generated by excitation by a high-frequency electric field or light. In general plasma CVD, since the plasma has a low pressure and the charged particles has a high kinetic energy, the charged particles are apt to collide with the surface of the thin film, thereby causing a defect in the thin film. In contrast, in radical CVD, since reaction gas molecules are decomposed and activated by the neutral radicals of an inert gas, it is possible to form a thin film on a substrate of a low temperature. The energy at a metastable level of an inert gas is 10 to 20 eV. If a large amount of neutral radicals are supplied onto the substrate, energy necessary for, the decomposition of, for example, $SiH_4$ and the rearrangement of the Si atoms which constitute the thin film formed on the substrate is sufficiently supplied.

Naturally, both the opposed-electrodes type plasma CVD apparatus A and the microwave plasma CVD apparatus are included in radical CVD apparatus from the fact that both utilize the long-life neutral radicals of an inert gas, but the radical CVD apparatus C is characterized in that the region in which the neutral radicals of an inert gas are generated and the film-forming region are separated from each other.

The radical CVD apparatus C is required to supply the neutral radicals of an inert gas having a very high density to the surface of the substrate, and for this reason, a reactor which is obtained by improving a part of reactor 23 of the microwave plasma CVD apparatus B is used. The other structure is the same as that of the microwave plasma CVD apparatus B, and explanation thereof will be omitted. As shown in Figs. 4 and 5, the reactor 29 of the apparatus C must generate the neutral radicals of an inert gas having a very high density and supply them onto the substrate. The region in which the neutral radicals of an inert gas are generated and the plasma region substantially coincide with each other and the inert gas is not activated out of the plasma region. Therefore, a quartz tube 30 is disposed at the central portion of the rectangualr cavity resonator 25 with the opening ends communicating with the supply port 16 and the outlet 17 so that the plasma region is positioned in the quartz tube 30 and the inert gas which flows into the reactor 29 passes through the plasma region. At this time, if the inner wall of the quartz tube 30 comes into contact with plasma, the density of the neutral radicals of the inert gas is lowered by the recombination on the inner wall. The diameter of the quartz tube 30 is therefore set at the necessary minimum.

A reaction space 31 is provided between the rectangular cavity resonator 25 and the outlet 17, and the reaction space 31 and the rectangular cavity resonator 25 are defined by a partition wall 32 provide with an opening 33 for supplying the neutral radicals therethrough. Although if the sectional area of the opening 33 is large, it is advantageous in forming a film uniformly on the substrate having a large area, the diameter is determined to be optimum to prevent the ingress of the reaction gas to the plasma region and in accordance with the output of the microwave generator 18. In addition, since the neutral radicals of the inert gas are recombined on the inner wall of the opening 33, the thicknesses of the opening 33 and the partition wall 32 are made as small as possible. The opening 33 may be replaced by a multiplicity of holes. In this case, the partition wall 32 may be a mesh. The substrate 1 which is held by a holder 34 substantially in parallel with the partition wall 32 is disposed in the reaction chamber 31. A gas supply pipe 35 for supplying the reaction gas is inserted between the substrate 1 and the partition wall 32.

All these three film-forming apparatuses described above as apparatuses suitable for carrying out the processes of the present invention have a structure for generating plasma of an inert gas by using a high frequency or a microwave in an R.F. band. In the present invention, it is also possible to generate neutral radicals by irradiating an inert gas with light having a shorter wave (including infrared rays and ultraviolet rays) so as to directly excite the inert gas. In this case, the wavelength of light is set at a wavelength which enables the light to be selectively and efficiently absorbed by the inert gas used.

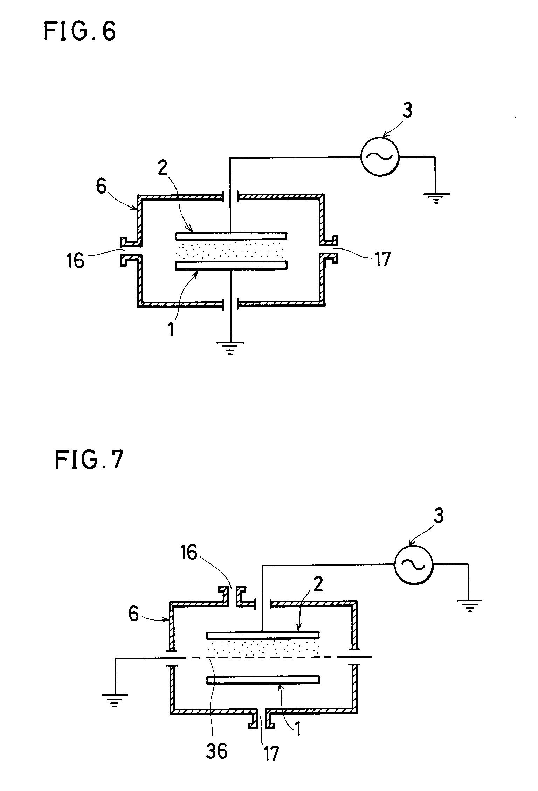

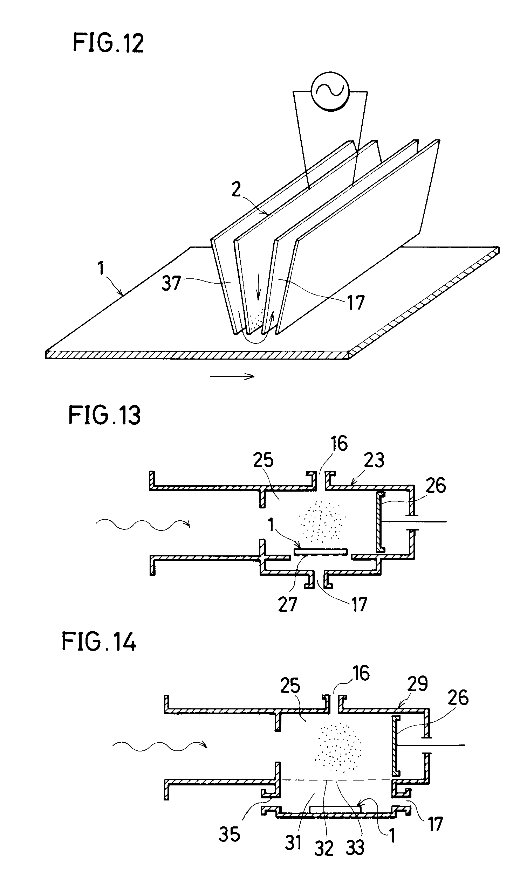

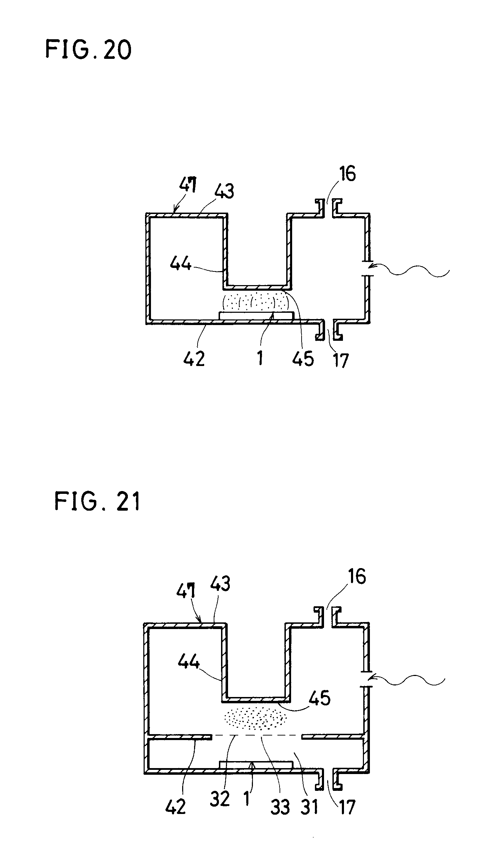

Embodiments of the present invention will now be explained with reference to the drawings showing the principle of the present invention. Figs. 6 to 12 show apparatuses of a type in which a high-frequency voltage is applied to an electrode, Figs. 13 to 19 and Figs. 22 and 23 show apparatuses of a type in which a microwave is used, and Fig. 20 and 21 show apparatuses of a type which are usable as either of the above-described types. In the apparatuses shown in Figs. 7, 8, 10, 12, 14, 16, 17, 19, 21, 22 and 23, the plasma region and the film-forming region are separated from each other. Each of these apparatuses will be explained in the following. The same reference numerals are provided for the elements which are the same as those shown in Figs. 1 to 5.

The apparatus shown in Fig. 6 has substantially the same structure as the opposed-electrodes type plasma CVD apparatus A. The reactor 6 accommodates a parallel plate electrode composed of the substrate 1 which is grounded and the electrode 2 which is connected to the high-frequency power source 3.

A mixture of an inert gas and a reaction gas is supplied from the supply port 16, and after plasma is generated between the substrate 1 and the electrode 2, the mixed gas is discharged from the outlet 17.

In the apparatus shown in Fig. 7, a grounded grid 36 is inserted between the substrate 1 and the electrode 2 which is connected to the high-frequency power source 3 such that the grid 36 is parallel to the substrate 1 and the electrode 2. Plasma is generated between the electrode 2 and the grid 36, and only the neutral radicals of the inert gas and the neutral radicals of the reaction gas generated in the plasma region are taken out through the grid 36. The neutral radicals of the inert gas and the reaction gas are further reacted in the gas phase between the grid 36 and the substrate 1, thereby generating the neutral radicals of the reaction gas and growing a thin film on the substrate 1.

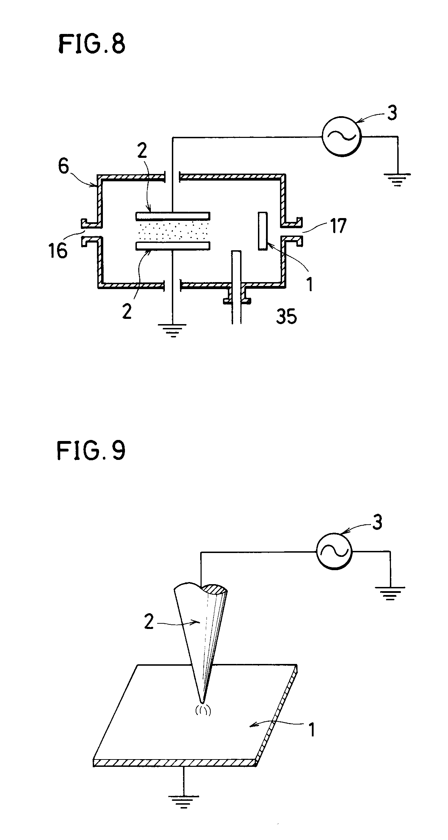

In the apparatus shown in Fig. 8, two electrodes 2 are disposed in parallel to each other in the reactor 6. One of the electrodes 2 is connected to the high-frequency power source 3 and the other is grounded. The substrate is on a longitudinal side of the electrodes 2 so as to be orthogonal thereto and to face the gap therebetween. An inert gas is introduced from the supply port 16, a reaction gas is supplied between the electrode 2 and the substrate 1 through a gas supply pipe 35, and each gas is discharged from the outlet 17.

In the apparatus shown in Fig. 9, the electrode 2 which is acicular and is connected to the high-frequency power source 3 is disposed in close proximity to the surface of the substrate 1. By changing the relative position of the substrate 1 and the electrode 2 by numerical control, a linear thin film having any given shape is formed on the substrate 1. It is also possible to form a thin film only at the necessary portion on the substrate 1.

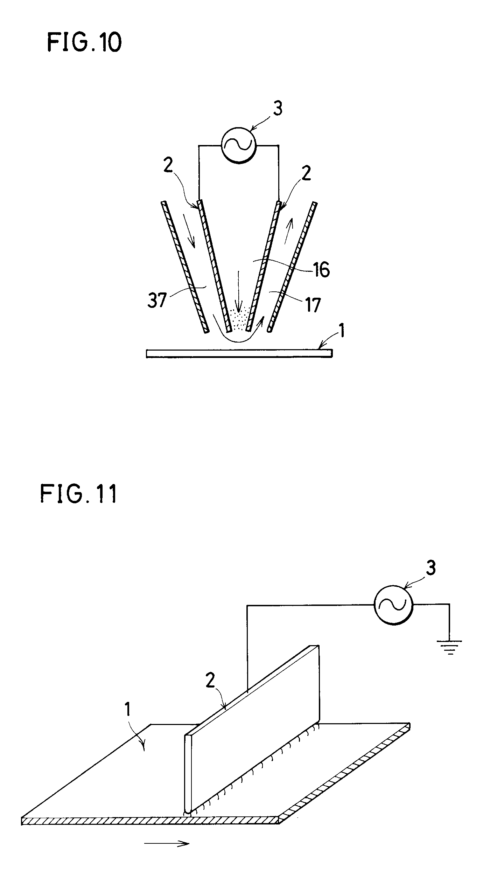

In the apparatus shown in Fig. 10, the supply port 16 for supplying an inert gas is provided at the central portion of the electrode 2 having a taper shape. A gas supply passage 37 for supplying a reaction gas is provided along one side surface of the electrode 2, while the outlet 17 is provided along the other side surface of the electrode. All of the supply port 16, the gas supply passage 37 and the outlet 17 are open at the forward end of the electrode 2. The inert gas supplied from the supply port 16 assumes plasma in a strong electric filed portion at the forward end on the inside of the electrode 2 and generates neutral radicals. The neutral radicals are pushed out of the forward end of the electrode 2 in a gas stream and activates the reaction gas which is introduced from the gas supply passage 37, thereby forming a thin film. Thereafter, the neutral radicals are discharged from the outlet 17. In this apparatus, a linear thin film is formed in the same way as in the apparatus shown in Fig. 9.

Fig. 11 shows an apparatus composed of the substrate 1 which is grounded and the long and planar blade electrode 2 which is orthogonal to the substrate 1 and disposed with one edge in close proximity to the substrate 1. By changing the relative position of the substrate 1 and the blade electrode 2, a thin film having a large area is continuously formed. This apparatus is suitable for forming a polymeric film having a shape of a continuous tape on the substrate 1.

The apparatus shown in Fig. 12 is obtained by extending the electrode 2 along the substrate 1 shown in Fig. 10. This structure enables continuous film forming in the same way as the blade electrode 2 shown in Fig. 11.

The apparatus shown in Fig. 13 has substantially the same structure as the microwave plasma CVD apparatus B shown in Fig. 3. Explanation thereof will be omitted.

Since the apparatus shown in Fig. 14 has the same structure as the apparatus shown in Figs. 4 and 5 except that the partition wall 32 is a mesh and the quartz pipe 30 is not provided, explanation thereof will be omitted.

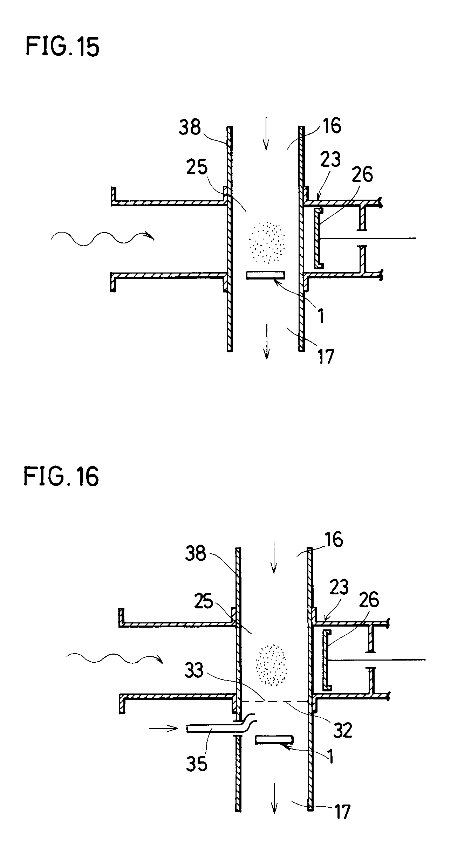

The apparatus shown in Fig. 15 is obtained by a providing a quartz reaction tube 38 in such a manner as to pierce through the rectangular cavity resonator 25 of the reactor 23. One end of the reaction tube 38 is used as the supply port 16 and the other end thereof is used as the outlet 17. The substrate 1 is disposed in the rectangular cavity resonator 25 or on the boundary. Plasma is generated from the inert gas and the reaction gas introduced from the supply port 16 of the reaction tube 38, and the neutral radicals of the reaction gas are generated by plasma excitation while these gases passes through the rectangular cavity resonator 25. The neutral radicals of the reaction gas are introduced onto the substrate in a gas stream together with the gases, thereby forming a thin film on the substrate 1.

The apparatus shown in Fig. 16 is obtained by providing the reticulate partition wall 32 on the boundary of the rectangular cavity resonator 25 on the outlet side of the apparatus shown in Fig. 15. The substrate 1 is disposed downstream from the partition wall 32 in proximity to the outlet. Plasma is generated from the inert gas introduced from the supply port 16 of the reaction tube 38 in the rectangular cavity resonator 25, and the plasma is taken out of the openings 33 of the partition wall 32. A reaction gas is supplied from the gas supply pipe 35 disposed between the partition wall 32 and the substrate 1 so as to react the reaction gas with the neutral radicals of the inert gas in the space between the partition wall 32 and the substrate 1, thereby generating the neutral radicals of the reaction gas. The neutral radicals generated are introduced onto the substrate 1 so as to form a thin film thereon, and each gas is discharged from the outlet 17 of the reaction tube 38.

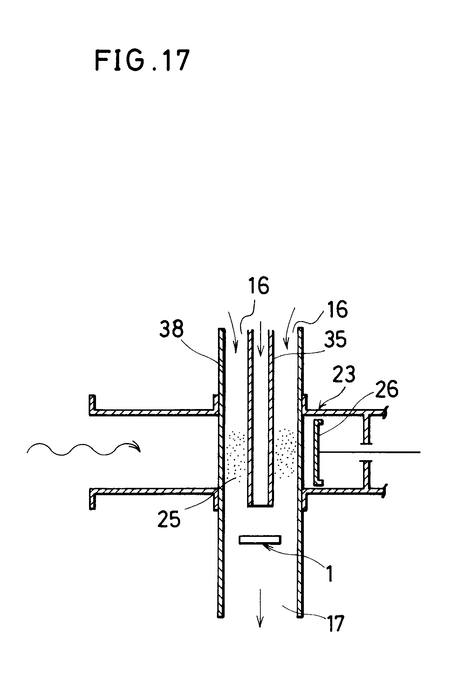

The apparatus shown in Fig. 17 has a similar structure to that of the apparatus shown in Fig. 15 but the gas supply pipe 35 is inserted into the central portion of the reaction tube 38 from the supply port 16 side, and the forward end of the gas supply pipe 35 is positioned slightly under the rectangular cavity resonator 25. The substrate 1 is disposed on the downstream side of the gas supply pipe 35. Plasma is generated from the inert gas supplied from the supply port 16 of the reaction tube 38 between the reaction tube 38 and the gas supply tube 35. The neutral radicals of the inert gas generated in the plasma region are taken out on the downstream side in the gas stream and mixed with the reaction gas introduced from the gas supply pipe 35 between the forward end of the gas supply pipe 35 and the substrate 1, thereby generating the neutral radicals of the reaction gas and forming a thin film on the substrate 1.

The apparatus shown in Fig. 13 is a modification of the apparatus shown in Fig. 13. The reactor 23 is beside the rectangular cavity resonator 25. An electrode plate 40 is connected to an antenna 39 which is drawn from the rectangular cavity resonator 25 to the reactor 23, and the substrate 1 is placed on and supported by the electrode plate 40. The walls of the waveguide, the rectangular cavity resonator 25, the reactor 23, etc. are all grounded and the electric field in the rectangular cavity resonator 25 is drawn to the electrode plate 40 by the antenna 39, thereby producing plasma in the reactor 23. The antenna 39 is drawn out in such a manner that the contact between the antenna 39 and the wall of the rectangular cavity resonator 25 is prevented by an insulator 41 such as teflon. The supply port 16 for a mixed gas such as He and $SiH_4$ and the outlet 17 are provided on the side wall of the reactor 23.

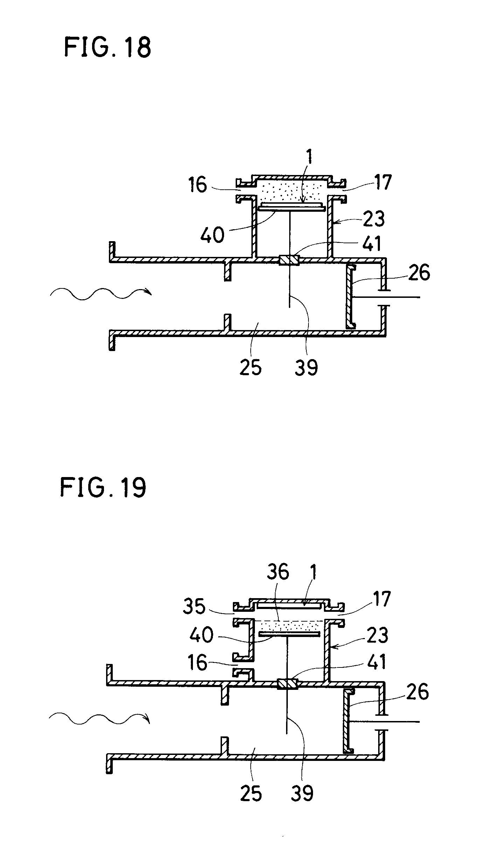

The apparatus shown in Fig. 19 is a modification of the apparatus shown in Fig. 14. In the same way as in the apparatus shown in Fig. 18, the reactor 23 is provided beside the rectangular cavity resonator 25. The electrode plate 40 is connected to the antenna 39 which is drawn from the rectangular cavity resonator 25 to the reactor 23, and the substrate 1 is mounted on the side wall of the reactor 23 which faces the electrode plate 40. A grid 36 is provided between the electrode plate 40 and the substrate 1. An inert gas such as He is introduced from the supply port 16 which is provided on the side wall of the reactor 23 on the opposite side of the grid 36 with respect to the electrode plate 40 to generate plasma between the electrode plate 40 and the grid 36. The neutral radicals of the inert gas which enter the substrate 1 side through the grid 36 are mixed with the reaction gas such as $SiH_4$ which is introduced from the gas supply pipe 35 provided on the side wall at the position between the grid 31 and the substrate 1, thereby activating the reaction gas and forming a film on the substrate 1. These gases are discharged from the outlet 17 provided on the side wall opposite to the side wall on which the supply port 16 is provided. In the same way as in the apparatus shown in Fig. 18, the reactors 23, the grid 36, etc. are all grounded.

In the apparatus shown in Fig. 20, a reactor 47 is a reentrant semicylindrical cavity resonator. An inner cylindrical portion 44 is extended in the axial direction from the center of a discal wall 43 toward the other discal wall 42, and a gap is formed between the end surface 45 of the inner cylindrical portion 44 and the discal wall 42. A high frequency is applied to the resonator or a microwave is introduced thereto, thereby producing a high voltage in the gap. Plasma is generated from th inert gas introduced from the supply port 16 of the reactor 47 and a reaction gas in the gap, and the neutral radicals of the reaction gas are generated by the excitation of the plasma. Thus, a thin film is formed on the substrate bonded to the discal wall 42.

The apparatus shown in Fig. 21 is obtained by adding the partition wall 32 to the structure shown in Fig. 20. The partition wall 32 is provided at the central portion of the discal wall 42, and the reaction space 31 is formed in such a manner as to surround the partition wall 32. The substrate is disposed in the reaction space 31 and the outlet 17 is provided in the reaction space 17. The neutral radicals of a reaction gas generated by plasma which are generated in the gap between the end surface 45 and the partition wall 32 are taken out of the openings 33 into the reaction space 31 and introduced onto the substrate 1, thereby forming a thin film on the substrate 1.

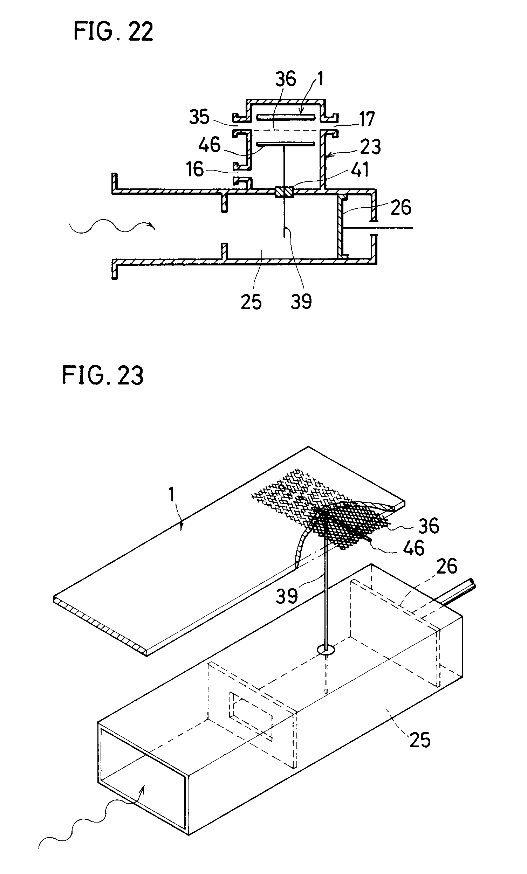

The apparatus shown in Figs. 22 and 23 is a modification of the apparatus shown in Fig. 19. The forward end of the antenna 39 is formed into a shape of T. Linear plasma is generated between the linear electrode 46 at the forward end of the antenna 39 and the grid 36 which is parallel to the linear electrode 46, and the neutral radicals of the inert gas generated in the plasma region are taken out through the grid 36. The neutral radicals of the inert gas are reacted with a reaction gas between the grid 36 and the substrate 1, thereby generating the neutral radicals of the reaction gas and forming a thin film on the substrate 1. By changing the relative position of the substrate 1 and the grid 36 while maintaining the parallel positions, it is possible to continuously form a thin film having a large area.

Embodiments of a film-forming process according to the present invention will now be explained with reference to the following examples.

Example 1

A thin film was formed on the substrate by the microwave plasma CVD apparatus B in the following procedure. As the substrate 1, a sapphire R surface, which is often used as an epitaxial growing surface of a silicon (100) face, was used.

(1) The substrate 1 was placed in the reactor 23, and after the reactor 23 was evacuated, the gas in the reactor was replaced by a carrier gas introduced thereinto.

(2) The pressure of the carrier gas was adjusted to about 50 Torr, and plasma was generated at a microwave power of 200 W.

(3) The carrier gas was caused to flow with the plasma maintained, and the reactor 23 was pressurized and the microwave power was increased so as to generate the plasma of the carrier gas at 500 W and under atmospheric pressure.

(4) With atmospheric pressure maintained, a mixture of $SiH_4$ as a reaction gas and the carrier gas was introduced to form a film at a microwave power of 500 W for several minutes. $SiH_4$ had a purity of not less than 99.99%, and contained $O_2$ (not more than 1 ppm), $SiH_3C\ell$ (not more than 5 ppm) and $H_2O$ (not more than 1 ppm) as the impurities.

In this way, film formation not under a low pressure but under atmospheric pressure was enabled. As the carrier gas, He or a mixed gas of He and Ar was used. An inert gas such as He and Ar has a long-life metastable level and imparts an energy to neutral gas molecules which collide with the inert gas, thereby activating them (Penning effect). He has two metastable levels $2^3S_1$ (19.82 eV) and $2^1S_0$ (10.61 eV). Especially $2^3D_1$ has a very long life (6 × $10^5$ sec), so that it is very effective for maintaining plasma. The closer the energy level of the neutral gas molecules are to the metastable level of an inert gas, the more prominent the Penning effect is. If an inert gas having a metastable level which is approximate to the metastable level of the reaction gas $SiH_4$ is used, the film-forming speed is increased. For this reason, Ar, which has two metastable levels $4^3P_2$ (11.55 eV) and $4^3P_0$ (11.72 eV) was also used as the carrier gas.

However, if Ar is used solely, when the pressure is raised to not less than 100 Torr, the plasma region becomes very narrow, which is inappropriate for film forming. This is because the mean free path of Ar is as short as about 1/3 of that of He. On the other hand, if He is used solely, the plasma region becomes wide to a certain degree. Ar is therefore preferably used in the form of a mixture with He.

The crystallinity of the thus-obtained silicon thin film was evaluated by reflection electron diffraction (RED) and Raman scattering spectrum. In RED, many diffraction rings were observed, and as a result of analysis of these rings, the thin film obtained proved to be a polycrystalline silicon film. In Raman scattering spectrum using an $Ar^+$ laser having a wavelength of 514.5 nm as the excitation light, there was a sharp peak at 520 $cm^{-1}$, which showed that the film was a polycrystalline silicon having a very good crystallinity.

Example 2

A thin film was formed on the substrate by the microwave plasma CVD apparatus A in the following procedure. As the substrate 1, a sapphire R surface was used.

(1) The substrate 1 was placed in the reactor 6, and the reactor 6 was evacuated.

(2) The carrier gas was caused to flow with the plasma maintained. After the reactor 23 was pressurized up to 5 atm, the reactor 5 was evacuated to 1 atm. This operation was repeated several times to sufficiently purge the reactor 6 so as to achieve the carrier gas atmosphere.

(3) The reaction gas and the carrier gas were mixed in the reserve tank 15, and the total pressure of the reserve tank was adjusted to 10 atm.

(4) The plasma of the carrier gas was produced between the substrate 1 and the electrode 2 in the reactor 6 at a power of 200 W output from the high-frequency power source 3, and the mixed gas in the reserve tank 15 was supplied between the the substrate 1 and the electrode 2 through the flow rate adjusting valve, thereby forming a film in 20 to 30 minutes.

The crystallinity of the thus-obtained silicon thin films were evaluated by reflection electron diffraction (RED) and Raman scattering spectrum in the same way as in Example 1, and the composition of the film was analyzed by Auger electron spectroscopy (AES). In RED, diffraction rings of silicon crystals were observed in the film produced by using a carrier gas of He and $SiH_4$ mixed in the ratio of 1000 : 1 and the film by using a carrier gas of He and $SiH_4$ mixed in the ratio of 3000 : 1, but a halo ring was observed in the film produced by using a carrier gas of He and $SiH_4$ mixed in the ratio of 10000 : 1. In Raman scattering spectrum, there was a peak showing crystalline silicon when the mixing ratio of He and $SiH_4$ was 1000 : 1, but when it was 3000 : 1, there was a broad peak showing amorphous silicon in addition to the peak showing crystalline silicon. In the analysis of the composition of the thin film, the existence of nitrogen in the thin film was observed, and the abundance ratio thereof corresponded to the partial pressure of $SiH_4$. The film produced by using a carrier gas of He and $SiH_4$ mixed in the ratio of 3000 : 1 contained about 10% of nitrogen, while the film produced by using a carrier gas of He and $SiH_4$ mixed in the ratio of 10000 : 1 contained no less than 30% of nitrogen. This nitrogen caused the disturbance of the crystallinity of a silicon thin film. He gas contains not more than $2 \times 10^{-3}$% of nitrogen as an impurity, and further contains oxygen, hydrocarbon, carbon dioxide and water to too large an amount to be negligible. In contrast, when a film was formed by using He gas having a high purity (99.9999%) and an impurity concentration lower by about two-digit figures, a polycrystalline silicon thin film was obtained even if the concentration of the reaction gas was low.

At first thought, the film-forming speed becomes higher as the partial pressure of $SiH_4$ is larger, so long as He a sufficient amount of He radicals exist. However, if the partial pressure of $SiH_4$ is large, the Si radicals generated in the plasma collide with each other a multiplicity of times until they reach the substrate, and silicon in the form of clusters deposits on the substrate. In order to increase the film-forming speed, it is therefore necessary to raise the partial pressure of $SiH_4$, narrow the film-forming gap between the substrate and the electrode in correspondence with the partial pressure and supply the maximum amount of mixed gas in the range which sufficiently maintains the plasma to the film-forming gap. If the film-forming gap is narrowed, it is also possible to suppress the influence of the impurities in the carrier gas.

As described above, according to a high-speed film-forming process by plasma CVD under a high pressure provided by the present invention, since reaction nuclei are decomposed or activated by the long-life neutral radicals of an inert gas which are excited by plasma or light under a high pressure such as several Torr to several atm, and the neutral radicals of the reaction gas are introduced onto a substrate to form a thin film, it is possible to generate neutral radicals having a high density by an inert gas which can easily generate and maintain plasma. In addition, since the life of the neutral radicals of an inert gas is long, a reaction cross section with a reaction gas becomes large, and it is possible to generate the neutral radicals of the reaction gas with high efficiency, thereby enabling high-speed film forming. Since the neutral radicals of an inert gas have a sufficiently high energy for electron state and a high density, it is possible to impart the energy to the thin film grown on the substrate, thereby enabling the rearrangement of the atoms of the thin film. Thus, it is possible to accelerate the crystallization of the thin film without the need for heating the substrate to a high temperature unlike a conventional process.

According to a high-speed film-forming process by radical CVD under a high pressure provided in the present invention, since the long-life neutral radicals of an inert gas are generated by excitation by plasma or light under a high pressure such as several Torr to several atm, only the neutral radicals are taken out to cause interaction with a reaction gas in the vicinity of a substrate, thereby decomposing or activating the reaction gas molecules, and the neutral radicals of the reaction gas are introduced onto the substrate to form a thin film on the substrate, it is possible to separate the plasma region from the film-forming region and film forming is possible without exposing the substrate directly to the plasma. Thus, it is possible to suppress defects such as the damage of the substrate caused by charged particles to the minimum and to form a crystallographically and physiologically excellent thin film.

In addition, since the neutral radicals of the inert gas imparts the energy in the electron state for the crystallization of a thin film as a sufficient energy, it is unnecessary to heat the substrate to a high temperature and the heating temperature between room temperature and 300°C is sufficient for the substrate. Therefore, the substrate is free from thermal damage and it is possible to form a crystallized thin film such as polycrystalline silicon film on a substrate of a cheap or low-melting material such as glass, metal plate and polymeric film.

**Claims**

1. A high-speed film-forming process by plasma CVD under a high pressure comprising the steps of: decomposing or activating reaction nuclei by the long-life neutral radicals of an inert gas which are generated by the excitation by plasma or light under a high pressure such as several Torr to several atm; and introducing the neutral radicals of the reaction gas generated thereby onto a substrate so as to form a thin film.

2. A high-speed film-forming process by plasma CVD under a high pressure according to Claim 1, wherein the long-life neutral radicals of the inert gas are generated by a high-frequency electromagnetic field of 10 MHz to 100 GHz or light.

3. A high-speed film-forming process by radical CVD under a high pressure comprising the steps of: generating the long-life neutral radicals of an inert gas by the excitation by plasma or light under a high pressure such as several Torr to several atm; decomposing or activating reaction nuclei by the interaction between the neutral radicals and reaction gas molecules; and introducing the neutral radicals of the reaction gas generated thereby onto a substrate so as to form a thin film.

4. A high-speed film-forming process by radical CVD under a high pressure according to Claim 3, wherein the long-life neutral radicals of the inert gas are generated by a high-frequency electromagnetic field of 10 MHz to 100 GHz or light.

5. A high-speed film-forming process by radical CVD under a high pressure comprising the steps of: generating and maintaining the plasma of an inert gas by a high-frequency electromagnetic field of 10 MHz to 100 GHz, generating the long-life radicals of an inert gas by the reaction between the plasma and the inert gas; taking out only the neutral radicals of the inert gas into a space different from the plasma region so as to decompose or activate reaction nuclei by the interaction between the neutral radicals and the reaction gas; and introducing the neutral radicals of the reaction gas generated thereby onto a substrate so as to form a thin film.

6. A high-speed film-forming process by radical CVD under a high pressure according to Claim 5, wherein a reactor accommodating a plate electrode and the substrate in parallel with each other with a grid therebetween is used; a mixture of the inert gas and the reaction gas is caused to continuously flow from the plate electrode to the substrate and a high-frequency voltage is applied between the plate electrode and the grid so as to generate the plasma of the inert gas therebetween; the plasma is reacted with the reaction gas until the neutral radicals of the inert gas generated in the plasma region reach the substrate through the grid; and the neutral radicals of the reaction gas are introduced onto the substrate by the interaction so as to grow the thin film on the substrate.

7. A high-speed film-forming process by radical CVD under a high pressure according to Claim 5, wherein a reactor accommodating two plate electrodes in parallel with each other and the substrate disposed so as to be orthogonal thereto and face the gap therebetween is used; a mixture of the inert gas and the reaction gas is caused to continuously flow from the opposite side of the substrate with respect to the electrodes to the substrate, the reaction gas is supplied between the electrodes and the substrate, and a high-frequency voltage is applied between the plate electrodes so as to generate the plasma of the inert gas therebetween; the plasma is reacted with the reaction gas until the neutral radicals of the inert gas generated in the plasma region reach the substrate beside the plate electrodes; and the neutral radicals of the reaction gas are introduced onto the substrate by the interaction so as to grow the thin film on the substrate.

8. A high-speed film-forming process by radical CVD under a high pressure according to Claim 5, wherein a reactor which accommodates a taper shaped electrode provided with a supply port at the forward end of the central portion thereof, a gas supply passage along one side surface and an outlet along the other side surface thereof, and the substrate in the vicinity of the forward end of the electrode is used; the inert gas jetted out of the supply port at the central portion of the electrode is caused to join the reaction gas jetted out of the gas supply passage in the vicinity of the forward end of the electrode; these gases are discharged from the outlet and a high-frequency voltage is applied to the electrode so as to generate the plasma of the inert gas at the forward end portion of the supply port of the electrode; the plasma is reacted with the reaction gas until the neutral radicals of the inert gas generated in the plasma region reach the substrate; and the neutral radicals of the reaction gas are introduced onto the substrate by the interaction so as to grow the thin film on the substrate.

9. A high-speed film-forming process by radical CVD under a high pressure comprising the steps of: preparing a cavity resonator having a reticulate partition wall as one side wall and provided with a reaction space outside of the partition wall; placing a substrate in the cavity resonator in parallel with the partition wall with a predetermined space therebetween; supplying an inert gas having a high pressure such as several Torr to several atm from the side wall opposing the partition wall; introducing the inert gas to the reaction space through the partition wall; introducing a reaction gas between the partition wall and the substrate from one side of the reaction space so that the reaction gas joins the inert gas; causing a gas flow which discharges the inert gas and the reaction gas from an outlet provided on the other side of the reaction space and generating the plasma of the inert gas in the cavity resonator by the microwave introduced thereinto; reacting the plasma with the reaction gas until the neutral radicals of the inert gas generated in the plasma region reach the substrate through the partition wall; and introducing the neutral radicals of the reaction gas generated thereby onto a substrate so as to grow a thin film.

10. A high-speed film-forming process by radical CVD under a high pressure comprising the steps of: preparing a cavity resonator and a quartz reaction tube piercing through the cavity resonator and having a reticulate partition wall on the boundary on the outlet side; placing a substrate downstream from the partition wall in proximity to the outlet; causing an inert gas having a high pressure such as several Torr to several atm to flow to the downstream from one end of the reaction tube; supplying a reaction gas between the partition wall and the substrate from a gas supply pipe; and discharging the inert gas and the reaction gas from the other end of the reaction tube; generating the plasma of the inert gas in the cavity resonator by the microwave introduced thereinto; reacting the plasma with the reaction gas until the neutral radicals of the inert gas generated in the plasma region reach the substrate through the partition wall; and introducing the neutral radicals of the reaction gas generated thereby onto a substrate so as to grow a thin film.

11. A high-speed film-forming process by radical CVD under a high pressure comprising the steps of: preparing a cavity resonator and a quartz reaction tube piercing through the cavity resonator and having a gas supply tube inserted from the upstream side such that the forward end thereof is positioned slightly under the cavity resonator; placing a substrate in the vicinity of the forward end of the gas supply tube; causing an inert gas having a high pressure such as several Torr to several atm to flow to the downstream from one end of the reaction tube; supplying a reaction gas from a gas supply pipe so as to cause a gas flow which causes the inert gas to join the reaction gas between the forward end of the gas supply pipe and the substrate; generating the plasma of the inert gas in the cavity resonator by the microwave introduced thereinto; reacting the plasma with the reaction gas until the neutral radicals of the inert gas generated in the plasma region reach the substrate; and introducing the neutral radicals of the reaction gas generated thereby onto a substrate so as to grow a thin film.

12. A high-speed film-forming process by radical CVD under a high pressure, preparing a reactor provided outside of the side wall of cavity resonator and accommodating an electrode which is connected to the forward end of an antenna led from the cavity resonator to the reactor, a substrate and a grounded grid disposed between the antenna and the substrate; supplying an inert gas having a high pressure such as several Torr to several atm from a supply port provided on the side wall of the reactor on the opposite side of the grid with respect to the electrode; supplying a reaction gas from a gas supply pipe provided on a side wall on one side of the reactor at the position between the grid and the substrate, discharging the inert gas and the reaction gas introduced between the grid and the electrode from an outlet provided on the side wall on the other side wall of the reactor through the grid; generating the plasma of the inert gas between the electrode and the grid by applying a high voltage to the electrode from the electric field in the cavity resonator which is drawn from the antenna by the microwave introduced thereinto; reacting the plasma with the reaction gas until the neutral radicals of the inert gas generated in the plasma region reach the substrate through the grid; and introducing the neutral radicals of the reaction gas generated thereby onto a substrate so as to grow a thin film.

13. A high-speed film-forming process by radical CVD under a high pressure according to Claim 12, wherein the electrode is a plate electrode, and a parallel plate electrode is constituted by the grid and the plate electrode.

14. A high-speed film-forming process by radical CVD under a high pressure according to Claim 12, wherein the the electrode is a linear electrode, and the linear electrode and the substrate are relatively changed while maintaining the parallel state.

15. A high-speed film-forming process by radical CVD under a high pressure comprising the steps of: preparing a reentrant semicylindrical cavity resonator composed of a discal wall as one side wall in the axial direction, an inner cylindrical portion which is extended in the axial direction from the center of a discal wall as the other side wall toward the discal wall as the one side wall in such a manner as to form a gap between the end surface of the inner cylindrical portion and the discal wall as the other side wall, a reticulate partition wall provided at the central portion of the discal wall as the one side surface and a reaction space surrounding the partition wall; placing a substrate in the reentrant cylindrical cavity resonator in parallel with the partition wall; introducing an inert gas and a reaction gas having a high pressure such as several Torr to several atm from a supply port provided at an appropriate position of the side wall of the reentrant cylindrical cavity resonator; supplying the mixture of the inert gas and the reaction gas to the reaction space through the partition wall and thereafter discharging the mixed gas from an outlet; generating the plasma of the inert gas by a high voltage produced between the end surface of the inner cylindrical portion and the partition wall by a high-frequency voltage applied to the reentrant cylindrical cavity resonator or the microwave introduced thereinto; reacting the plasma with the reaction gas until the neutral radicals of the inert gas generated in the plasma region reach the substrate through the partition wall; and introducing the neutral radicals of the reaction gas generated thereby onto a substrate so as to grow a thin film.

FIG.1

FIG. 2

FIG . 3

FIG. 4

FIG. 5

FIG.6

FIG.7

FIG.8

FIG.9

FIG.10

FIG.11

FIG.12

FIG.13

FIG.14

FIG.15

FIG.16

# FIG.17

FIG. 18

FIG. 19

FIG. 20

FIG. 21

FIG. 22

FIG. 23